# EUROPÄISCHE PATENTSCHRIFT

(11) **EP 3 074 782 B1**
(45) Veröffentlichungstag und Bekanntmachung des Hinweises auf die Patenterteilung: **22.09.2021**
(21) Anmeldenummer: 14787117.2
(22) Anmeldetag: 09.10.2014
(51) Int. Cl.: G01R 31/385, G01R 31/00

(54) **VORRICHTUNG UND VERFAHREN ZUM PRÜFEN EINER FAHRZEUGBATTERIE**
DEVICE AND METHOD FOR TESTING A VEHICLE BATTERY
DISPOSITIF ET PROCÉDÉ POUR TESTER UNE BATTERIE DE VÉHICULE

(30) Priorität: 28.11.2013 DE 102013224344
(43) Veröffentlichungstag der Anmeldung: 05.10.2016
(73) Patentinhaber: Robert Bosch GmbH, 70442 Stuttgart (DE)
(72) Erfinder: EITEL, Peter, 73730 Esslingen (DE); WANG, Xin, 73733 Esslingen Am Neckar (DE); WICKERT, Stefan, 73095 Albershausen (DE); HAGEMANN, Philipp, 73614 Schorndorf (DE); SIEGEL, Guenter, 73614 Schorndorf - Weiler (DE); WALTER, Andreas, 71665 Vaihingen (Enz) (DE)
(86) Internationale Anmeldenummer: PCT/EP2014/071600
(87) Internationale Veröffentlichungsnummer: WO 2015/078630

(56) Entgegenhaltungen:
- WO-A2-2009/011875
- US-A1- 2008 315 830
- US-A1- 2012 119 747

## Beschreibung

Die vorliegende Erfindung betrifft eine Vorrichtung und ein Verfahren zum Prüfen einer Fahrzeugbatterie in einem aus einem Fahrzeug ausgebauten Zustand mittels einer Prüfvorrichtung, welche zum Prüfen der in das Fahrzeug eingebauten Fahrzeugbatterie mittels einer On-Board-Diagnose-Schnittstelle des Fahrzeugs ausgebildet ist.

Unter einer Fahrzeugbatterie sollen insbesondere solche Batterien verstanden sein, welche in Hybrid- oder Elektrofahrzeugen die Aufgabe haben, dem Antriebsstrang elektrische Energie zuzuführen. Solche Fahrzeugbatterien werden üblicherweise in einer Werkstatt mittels einer Prüfvorrichtung diagnostiziert, beispielsweise mittels eines Diagnosetesters. Diagnosetester sind oft allgemein zur Diagnose von Fahrzeugen ausgebildet. Die Verbindung der Prüfvorrichtung mit der Fahrzeugbatterie erfolgt häufig über eine genormte On-Board-Diagnose-(OBD)-Schnittstelle, welche an dem Fahrzeug ausgebildet ist. Eine solche Norm kann beispielsweise die OBD-I, OBD-II, OBD-1.5 oder die EOBD-Norm sein.

Bei Hybrid- und Elektrofahrzeugen ist es im Fehlerfall häufig notwendig, die Fahrzeugbatterie, beispielsweise eine Hochvoltbatterie, auszubauen. Diese ausgebaute Fahrzeugbatterie muss in dem aus dem Fahrzeug ausgebauten Zustand hinsichtlich ihrer Funktionalität weiter überprüft bzw. diagnostiziert werden. Die vorhandene Diagnoseinfrastruktur, insbesondere die Prüfvorrichtung, kann für die demontierte Fahrzeugbatterie in der Werkstatt in der Regel nicht mehr verwendet werden, da die Fahrzeugbatterie selbst mehr über die On-Board-Diagnose-Schnittstelle verfügt.

In der WO/2009 011875 A2 sind ein Verfahren und ein Gerät zum Testen eines elektrischen Fahrzeugs beschrieben. Das Gerät weist einen Datenbusverbinder auf, welcher an einem Datenbus des elektrischen Fahrzeugs anschließbar ist. Der Datenbus kann auch ein OBD-Datenbus sein. Das Gerät weist weiterhin einen Mikroprozessor auf, welcher über den Datenbus Spannungs- und Strominformationen über den Datenbus des elektrischen Fahrzeugs auslesen kann und welcher den Betrieb des Fahrzeugs basierend auf den abgelesenen Strom- und Spannungsinformationen diagnostizieren kann.

In der US 2008/0315830 A1 ist ein elektronischer Batterietester mit einer Datenbusverbindung beschrieben. Ein Batterietestschaltkreis ist mit einer Batterie verbindbar und kann über einen Datenbus Infomationen z.B. von einem Fahrzeug erhalten.

In der US 2012/0119747 A1 ist ein Verfahren zum Bestätigen eines Ladezustands einer Fahrzeugbatterie beschrieben.

### Offenbarung der Erfindung

Die vorliegende Erfindung offenbart eine Vorrichtung mit den Merkmalen des Patentanspruchs 1 und ein Verfahren mit den Merkmalen des Patentanspruchs 10.

Demgemäß ist eine Vorrichtung zum Prüfen einer Fahrzeugbatterie in einem aus einem Fahrzeug ausgebauten Zustand mittels einer Prüfvorrichtung vorgesehen, wobei die Prüfvorrichtung zum Prüfen der in das Fahrzeug eingebauten Fahrzeugbatterie mittels einer On-Board-Diagnose-Schnittstelle des Fahrzeugs ausgebildet ist.

Die Vorrichtung weist eine Schnittstelle auf, an welche ein Stecker der Prüfvorrichtung anschließbar ist, welcher zum Anschluss an die On-Board-Diagnose-Schnittstelle des Fahrzeugs ausgebildet ist. Die Vorrichtung weist weiterhin eine elektrische Anschlusseinrichtung auf, mittels welcher mindestens ein elektrischer Fahrzeugbatterie-Anschluss der Fahrzeugbatterie mit der Vorrichtung verbindbar ist.

Weiterhin umfasst die erfindungsgemäße Vorrichtung eine Adaptereinrichtung, mittels welcher Signale, welche von dem mindestens einen elektrischen Fahrzeugbatterie-Anschluss der Fahrzeugbatterie über die Anschlusseinrichtung empfangbar sind, an die Schnittstelle derart leitbar sind, dass die Signale an der Schnittstelle für die Prüfvorrichtung entsprechend der Konfiguration der On-Board-Diagnose-Schnittstelle des Fahrzeugs prüfbar sind. Mit "entsprechend der Konfiguration der On-Board-Diagnose-Schnittstelle" ist insbesondere gemeint, dass die Signale an der Schnittstelle für die Prüfvorrichtung derart anliegen, wie die Signale, welche von dem mindestens einen Fahrzeugbatterie-Anschluss der Fahrzeugbatterie empfangbar sind, an der On-Board-Diagnose-Schnittstelle des Fahrzeugs anlägen, befände sich die Fahrzeugbatterie noch in einem in das Fahrzeug eingebauten Zustand. Das heißt, die Prüfvorrichtung erhält beispielsweise an dem Stecker die gleichen Signale, egal ob der Stecker in die On-Board-Diagnose-Schnittstelle des Fahrzeugs oder aber in die Schnittstelle der Vorrichtung angeschlossen ist.

Es können auch Signale, welche von der Prüfvorrichtung ausgehen, von der Vorrichtung über die Schnittstelle entsprechend der Konfiguration der On-Board-Diagnose-Schnittstelle empfangbar und über die Adaptereinrichtung an die Anschlusseinrichtung leitbar sein. Über die Anschlusseinrichtung können die von der Prüfvorrichtung ausgehenden Signale an die Fahrzeugbatterie entsprechend der Konfiguration der On-Board-Diagnose-Schnittstelle anlegbar sein. Mit "entsprechend der Konfiguration der On-Board-Diagnose-Schnittstelle" ist insbesondere gemeint, dass die Signale an der Schnittstelle für die Prüfvorrichtung derart eingekoppelt werden, und nach dem Leiten durch die Adaptereinrichtung über die Anschlusseinrichtung an die Fahrzeugbatterie an der Fahrzeugbatterie derart anliegen, wie die Signale an der Fahrzeugbatterie anlägen, wäre die Prüfvorrichtung über die On-Board-Diagnose-Schnittstelle des Fahrzeugs mit der Fahrzeugbatterie in dem in das Fahrzeug eingebauten Zustand verbunden.

Weiterhin ist ein Verfahren zum Prüfen einer Fahrzeugbatterie in einem aus einem Fahrzeug ausgebauten Zustand mittels einer Prüfvorrichtung vorgesehen, welche zum Prüfen der in das Fahrzeug eingebauten Fahrzeugbatterie mittels einer On-Board-Diagnose-Schnittstelle des Fahrzeugs ausgebildet ist. Das Verfahren umfasst die Schritte: Verbinden mindestens eines elektrischen Fahrzeugbatterie-Anschlusses der Fahrzeugbatterie mit einer elektrischen Anschlusseinrichtung; Verbinden eines Steckers der Prüfvorrichtung, wobei der Stecker zum Anschluss an die On-Board-Diagnose-Schnittstelle des Fahrzeugs anschließbar ist, mit einer Schnittstelle; Leiten von Signalen, welche von dem mindestens einen elektrischen Fahrzeugbatterie-Anschluss der Fahrzeugbatterie ausgehen derart an die Schnittstelle, dass die Signale an der Schnittstelle für die Prüfvorrichtung mittels des Steckers entsprechend der Konfiguration der On-Board-Diagnose-Schnittstelle des Fahrzeugs prüfbar sind; Prüfen der Signale entsprechend der Konfiguration der On-Board-Diagnose-Schnittstelle des Fahrzeugs.

### Vorteile der Erfindung

Die der vorliegenden Erfindung zugrunde liegende Erkenntnis besteht darin, dass Werkstätten üblicherweise über technisch aufwändige, hochspezialisierte Prüfvorrichtungen als Diagnosetester zum Prüfen von in einem Fahrzeug eingebauten Fahrzeugbatterien verfügen, diese Prüfvorrichtungen allerdings auf Fahrzeugbatterien in einem aus dem Fahrzeug ausgebauten Zustand aufgrund der fehlenden On-Board-Diagnose-Schnittstelle nicht anwendbar sind.

Die der vorliegenden Erfindung zugrunde liegende Idee besteht nun darin, dieser Erkenntnis Rechnung zu tragen und eine Vorrichtung bereitzustellen, mittels welcher eine bereits bestehende Prüf-Infrastruktur, das heißt die Prüfvorrichtung, auch auf aus einem Fahrzeug ausgebaute Fahrzeugbatterien anwendbar ist. Die Vorrichtung erfüllt dabei zumindest eine Adapterfunktion. Somit kann technischer und finanzieller Aufwand für zusätzliche Diagnoseinfrastruktur-Elemente zur Diagnose von ausgebauten Fahrzeugbatterien sowie für Transporte der Fahrzeugbatterie zur Diagnose und Instandsetzung minimiert werden oder ganz entfallen.

Vorteilhafte Ausführungsformen und Weiterbildungen ergeben sich aus den Unteransprüchen sowie aus der Beschreibung unter Bezugnahme auf die Figuren.

Gemäß einer bevorzugten Weiterbildung umfasst die Anschlusseinrichtung der Vorrichtung zumindest einen ersten Spannungsanschluss und einen zweiten Spannungsanschluss, an welche eine mittels der Fahrzeugbatterie erzeugte Spannung anlegbar ist. Weiterhin ist die Adaptereinrichtung mit den Spannungsanschlüssen und der Schnittstelle derart verbunden und so ausgebildet, dass zumindest die zwischen den Spannungsanschlüssen angelegte Spannung für die Prüfvorrichtung zum Prüfen der Fahrzeugbatterie an die Schnittstelle derart leitbar ist, dass die Spannung an der Schnittstelle entsprechend der Konfiguration der On-Board-Diagnose-Schnittstelle prüfbar ist. Hierdurch können verschiedene Hochvolt-, aber auch Niedervolt-Ausgänge der Fahrzeugbatterie überprüft werden.

Gemäß einer weiteren bevorzugten Weiterbildung der Vorrichtung weist die Vorrichtung einen Spannungsversorgungsanschluss auf, mittels welchem eine Betriebsspannung in die Vorrichtung einkoppelbar ist. Die Betriebsspannung kann mittels der Adaptereinrichtung derart an die Schnittstelle leitbar sein, dass die Betriebsspannung zum Betrieb der Prüfvorrichtung an der Schnittstelle abgreifbar ist. Somit ist für die Prüfvorrichtung keine weitere externe Energiequelle nötig. Weiterhin können somit auch Prüfvorrichtungen eingesetzt werden, welche eine Energieversorgung über die On-Board-Diagnose-Schnittstelle des Fahrzeugs erwarten.

Vorteilhafterweise ist ein Kommunikationsprotokoll, mittels welchem die Adaptereinrichtung die Signale an die Schnittstelle leitet, basierend auf vorbestimmten und/oder eingebbaren Informationen über die Fahrzeugbatterie einstellbar. Somit können auch Prüfvorrichtungen verwendet werden, welche zum Funktionieren an der Schnittstelle der Vorrichtung Informationen mittels eines bestimmten Kommunikationsprotokolls erfordern. Bei solchen Kommunikationsprotokollen kann es sich beispielsweise um Batterie- und/oder fahrzeugherstellerspezifische Kommunikationsprotokolle handeln. In der Vorrichtung kann ein Datenspeicher ausgebildet sein, in welchem Kommunikationsprotokolle vorprogrammiert sind und welche von einer Kommunikationsprotokoll-Auswahleinrichtung der Vorrichtung automatisch, beispielsweise basierend auf von der Fahrzeugbatterie ausgehenden Datensignalen, ausgewählt und eingesetzt werden.

Alternativ oder zusätzlich kann die Vorrichtung über eine Anzeige- und Eingabeeinrichtung verfügen, über welche ein zu verwendendes Kommunikationsprotokoll eingebbar ist. Alternativ oder zusätzlich kann auch über die Prüfvorrichtung, welche über den Stecker mit der Schnittstelle der Vorrichtung verbunden ist, eingebbar sein, mittels welchem Kommunikationsprotokoll die Adaptereinrichtung die Signale an die Schnittstelle leitet. Durch die vorbestimmten und/oder eingebbaren Kommunikationsprotokolle kann die Vorrichtung sehr vielseitig auf eine Vielzahl von Prüfvorrichtungen und/oder Fahrzeugen und/oder Fahrzeugbatterien einstellbar sein.

Gemäß einer weiteren bevorzugten Weiterbildung ist eine Schaltung, mittels welcher die Adaptereinrichtung die Signale an die Schnittstelle leitet, basierend auf vorbestimmten und/oder eingebbaren Informationen über die Fahrzeugbatterie und/oder über das Fahrzeug einstellbar. Auch hierdurch kann die Vorrichtung sehr vielseitig auf eine Vielzahl von Prüfvorrichtungen und/oder Fahrzeugen und/oder Fahrzeugbatterien einstellbar sein.

Gemäß einer weiteren bevorzugten Weiterbildung weist die Vorrichtung eine Lade-Steuerschnittstelle auf, mittels welcher ein an die Lade-Steuerschnittstelle angeschlossenes Ladegerät zum Auf- und/oder Entladen der Fahrzeugbatterie gemäß vorbestimmten und/oder bestimmbaren Ladeparametern steuerbar ist. Die Lade-Steuerschnittstelle kann dabei derart mit der Schnittstelle der Vorrichtung verbunden sein, dass die Prüfvorrichtung das angeschlossene Ladegerät, beispielsweise zum Prüfen der Fahrzeugbatterie, mittels der Lade-Steuerschnittstelle steuern kann. Hierdurch kann das Prüfen der Fahrzeugbatterie in einer Vielzahl von Situationen und mit einer Vielzahl von Parametern durchgeführt werden. Die Ladeparameter können durch die Lade-Steuerschnittstelle automatisch bestimmbar sein, beispielsweise basierend auf von der Fahrzeugbatterie ausgehenden Datensignalen. Die Vorrichtung kann somit als ein Ladegerät mit einer On-Board-Diagnose-Schnittstelle-kompatiblen Schnittstelle eingesetzt werden.

Gemäß einer weiteren bevorzugten Weiterbildung umfasst die Vorrichtung eine Ladeeinrichtung, mittels welcher die Fahrzeugbatterie über die Anschlusseinrichtung auf- und/oder entladbar ist. Die oben in Bezug auf ein angeschlossenes Ladegerät beschriebenen Vorteile sind somit auch ohne ein externes Ladegerät verfügbar. Die Lade-Steuerschnittstelle kann zusätzlich oder auch ausschließlich zum Steuern des Auf- und/oder Entladens der Fahrzeugbatterie mittels der Ladeeinrichtung ausgebildet sein.

Gemäß einer weiteren bevorzugten Weiterbildung umfasst die Anschlusseinrichtung der Vorrichtung mindestens einen Datenanschluss, mittels welchem Daten empfangbar sind, welche von mindestens einem Datenausgang der Fahrzeugbatterie ausgebbar sind. Die Adaptereinrichtung ist mit dem mindestens einen Datenanschluss und der Schnittstelle derart verbunden und ist derart ausgebildet, dass die über den Datenanschluss empfangenen Daten für die Prüfvorrichtung zum Prüfen der Fahrzeugbatterie derart an die Schnittstelle leitbar sind, dass die Daten an der Schnittstelle entsprechend der Konfiguration der On-Board-Diagnose-Schnittstelle prüfbar sind.

Gemäß einer besonders bevorzugten Weiterbildung umfasst die Vorrichtung eine Simulationseinrichtung, mittels welcher eine Fahrzeugsimulation, insbesondere eine Fahrzeugrestsimulation, mit vorbestimmten und/oder bestimmbaren Parametern durchführbar ist. Fahrzeugsimulationsdaten der Fahrzeugsimulation sind über den mindestens einen Datenanschluss an die Fahrzeugbatterie sendbar. Die Fahrzeugsimulationsdaten können derart beschaffen sein, dass die Fahrzeugbatterie auf die Fahrzeugsimulationsdaten reagiert, als befände sie sich in dem Fahrzeug mit den vorbestimmten und/oder bestimmbaren Parametern. Das heißt, für die Fahrzeugbatterie ist nicht erkennbar, dass sie sich nicht in dem Fahrzeug mit den vorbestimmten und/oder bestimmbaren Parametern befindet. Die Parameter können auch durch Eingaben an der Prüfvorrichtung, welche über die Schnittstelle mit der erfindungsgemäßen Vorrichtung verbunden ist, bestimmt werden.

Fahrzeugbatterien können beispielsweise über Schutzmechanismen verfügen, gemäß welchen sie Schütze nur öffnen, wenn etwa eine Kühlvorrichtung des Fahrzeugs ein Erlaubnissignal liefert. Ist das Schließen eines solchen Schutzes für das Prüfen der Fahrzeugbatterie vorteilhaft, kann mittels der Simulationseinrichtung beispielsweise eine Fahrzeugsimulation durchgeführt werden, in welcher auch die Kühlvorrichtung simuliert wird. Die Fahrzeugsimulationsdaten der Fahrzeugsimulation können in diesem Fall das Erlaubnissignal der simulierten Kühlvorrichtung umfassen, welches an die Fahrzeugbatterie sendbar ist. Weitere Fahrzeugsimulationsdaten können beispielsweise Informationen über eine Temperatur, einen Fahrzustand des Fahrzeugs oder ähnliches umfassen. Die Parameter der Fahrzeugsimulation können vorbestimmt, das heißt vorprogrammiert sein, sie können aber auch von einem Benutzer und/oder automatisch bestimmbar sein.

### Kurze Beschreibung der Zeichnungen

Die vorliegende Erfindung wird nachfolgend anhand der in den schematischen Figuren der Zeichnungen dargestellten Ausführungsbeispiele näher erläutert. Es zeigen:
- Fig. 1: ein schematisches Blockschaltbild einer erfindungsgemäßen Vorrichtung zum Prüfen einer Fahrzeugbatterie gemäß einem ersten Aspekt der vorliegenden Erfindung; und
- Fig. 2: ein schematisches Flussdiagramm zum Erläutern eines Verfahrens gemäß einem zweiten Aspekt der vorliegenden Erfindung.

In allen Figuren sind gleiche bzw. funktionsgleiche Elemente und Vorrichtungen - sofern nichts anderes angegeben ist - mit denselben Bezugszeichen versehen.

### Beschreibung der Ausführungsbeispiele

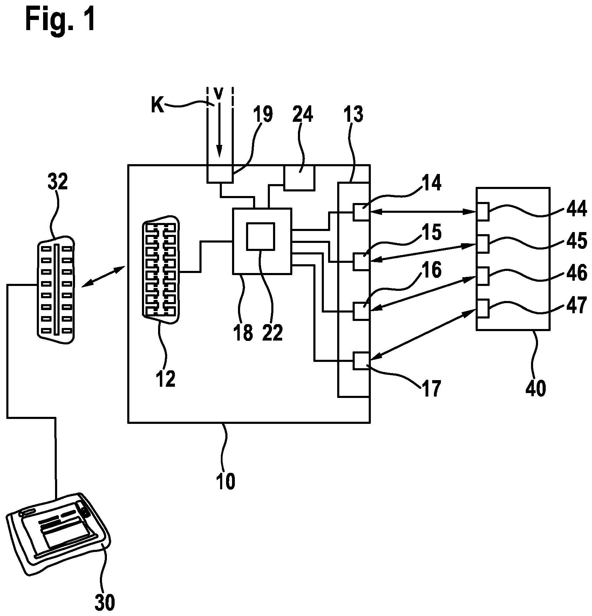

Fig. 1 zeigt ein schematisches Blockschaltbild einer erfindungsgemäßen Vorrichtung 10 zum Prüfen einer Fahrzeugbatterie 40 in einem aus einem Fahrzeug ausgebauten Zustand mittels einer Prüfvorrichtung 30, welche zum Prüfen der in das Fahrzeug eingebauten Fahrzeugbatterie 40 mittels einer On-Board-Diagnose-Schnittstelle des Fahrzeugs ausgebildet ist, gemäß einem ersten Aspekt der vorliegenden Erfindung.

Zur Verdeutlichung des Verfahrens sind in Fig. 1 auch die Prüfvorrichtung 30 und die Fahrzeugbatterie 40 abgebildet. Doppelpfeile symbolisieren, wie Anschlüsse gemäß dem ersten Aspekt miteinander verbindbar sein können. Wenn im folgenden Text davon die Rede ist, dass Signale von der Fahrzeugbatterie 40 an die Vorrichtung 10 und/oder umgekehrt, und/oder von der Prüfvorrichtung 30 an die Vorrichtung 10 und/oder umgekehrt entsprechend einer bestimmten Konfiguration sendbar sind, so soll damit stets verstanden sein, dass dies bei einem bestimmungsgemäßen Anschließen der Prüfvorrichtung 30 an die Vorrichtung 10 bzw. der Fahrzeugbatterie 40 an die Vorrichtung 10 der Fall ist.

Die Vorrichtung weist eine Schnittstelle 12 auf, an welche ein Stecker 32 der Prüfvorrichtung 30 anschließbar ist, welcher zum Anschluss an die On-Board-Diagnose-Schnittstelle des Fahrzeugs ausgebildet ist. Gemäß Fig. 1 ist die On-Board-Diagnose-Schnittstelle des Fahrzeugs eine OBD-Schnittstelle mit dem standardisierten OBD-Protokoll. Dabei kann es sich um OBD-I, OBD-1.5 oder OBD-II handeln. In Fig. 1 ist die Schnittstelle 12 baugleich mit einem weiblichen OBD-Verbindungsport ausgebildet, während der Stecker 32 der Prüfvorrichtung als männlicher OBD-Verbindungsport ausgebildet ist.

Die Schnittstelle 12 ist mit einer Adaptereinrichtung 18 derart verbunden, dass mittels der Adaptereinrichtung 18 alle Kontaktpins der Schnittstelle 12 mit Datensignalen- und/oder Spannungen individuell beaufschlagbar sind. Gemäß Fig. 1 weist die Vorrichtung 10 weiterhin einen Spannungsversorgungsanschluss 19 auf. An den Spannungsversorgungsanschluss 19 ist ein externes Versorgungskabel K anschließbar. Über das Versorgungskabel K kann eine Betriebsspannung V in die Vorrichtung 10 eingekoppelt werden. Mit der Betriebsspannung V kann beispielsweise die Vorrichtung 10 betrieben werden.

Die Betriebsspannung V kann auch mittels der Adaptereinrichtung 18 an die Schnittstelle 12 derart leitbar sein, dass die Betriebsspannung V oder zumindest ein Teil der Betriebsspannung V zum Betrieb der Prüfvorrichtung 30 an der Schnittstelle 12 abgreifbar ist. Beispielsweise kann die Betriebsspannung V zwölf Volt oder mehr betragen, und die Prüfvorrichtung 30 kann mit zwölf Volt der Betriebsspannung V betrieben werden.

Die Vorrichtung 10 weist weiterhin eine Lade-Steuerschnittstelle 24 auf, an welche ein externes Ladegerät anschließbar ist. Das Ladegerät kann zum Auf- und/oder Entladen der Fahrzeugbatterie 40 ausgebildet sein. Das Auf- und/oder Entladen der Fahrzeugbatterie 40 mittels des externen Ladegeräts kann entweder über ein externes Kabel zwischen dem Ladegerät und der Fahrzeugbatterie 40 erfolgen, es kann aber auch über die Vorrichtung 10, beispielsweise über die Adaptereinrichtung 18 erfolgen, welche mit einer Anschlusseinrichtung 13 verbunden ist.

Gemäß Fig. 1 weist die Anschlusseinrichtung 13 einen ersten Spannungsanschluss 16 und einen zweiten Spannungsanschluss 17 auf. Der erste und der zweite Spannungsanschluss 16, 17 sind mit einem dritten und einem vierten Spannungsanschluss 46, 47 der Fahrzeugbatterie 40 verbindbar, so dass etwa eine zwischen dem dritten Spannungsanschluss 46 und dem vierten Spannungsausgang 47 bestehende, von der Fahrzeugbatterie 40 erzeugte Spannung über die Adaptereinrichtung 18 an die Schnittstelle 12 leitbar ist.

Über die Adaptereinrichtung 18 und die Lade-Steuerschnittstelle 24 kann auch das externe Ladegerät zum Auf- und/oder Entladen der Fahrzeugbatterie 40 eine Spannung an den ersten und zweiten Spannungsanschluss 16, 17 und damit an den dritten und vierten Spannungsanschluss 46, 47 der Fahrzeugbatterie 40 anlegen. Ein Steuergerät der Fahrzeugbatterie kann hierdurch mit Spannung versorgt werden. Die Spannungsanschlüsse 46, 47 der Fahrzeugbatterie 40 können insbesondere Hochvolt-Spannungsanschlüsse, beispielsweise ein Hochvolt-Eingang und ein Hochvolt-Ausgang sein.

Die Anschlusseinrichtung 13 weist weiterhin einen ersten Datenanschluss 14 auf, mittels welchem Daten empfangbar sind, welche mittels mindestens eines Datenausgangs 44 der Fahrzeugbatterie 40 ausgebbar sind. Weiterhin weist die Anschlusseinrichtung 13 einen zweiten Datenanschluss 15 auf, mittels welchem Daten an einen Dateneingang 45 der Fahrzeugbatterie 40 sendbar sind. Bei dem Datenausgang 44 und/oder dem Dateneingang 45 der Fahrzeugbatterie 40 kann es sich beispielsweise um einen oder mehrere Niedervolt-Anschlüsse handeln, welche teilweise auch zum Anschluss an einen CAN-Bus oder einen vergleichbaren Bus-Standard für Fahrzeuge ausgebildet sein können.

Die Adaptereinrichtung 18 ist derart mit dem ersten Datenanschluss 14 und der Schnittstelle 12 verbunden und so ausgebildet, dass die über den ersten Datenanschluss 14 empfangenen Daten für die Prüfvorrichtung 30 zum Prüfen der Fahrzeugbatterie 30 derart an die Schnittstelle 12 leitbar sind, dass die Daten an der Schnittstelle 12 entsprechend der Konfiguration der On-Board-Diagnose-Schnittstelle prüfbar sind.

Weiterhin ist die Adaptereinrichtung 18 derart mit dem zweiten Datenanschluss 15 und der Schnittstelle 12 verbunden und so ausgebildet, dass an der Schnittstelle 12 von der Prüfvorrichtung 30 entsprechend der Konfiguration der On-Board-Diagnose-Schnittstelle empfangbare Daten derart an den zweiten Datenanschluss 15 leitbar sind, dass die Daten entsprechend der Konfiguration der On-Board-Diagnose-Schnittstelle an den Dateneingang 45 der Fahrzeugbatterie anlegbar sind.

Die empfangenen Daten können beispielsweise interne Messdaten der Fahrzeugbatterie 40, Informationen über einen Hersteller und/oder ein Modell der Fahrzeugbatterie und/oder des Fahrzeugs, Informationen über ein zu verwendendes oder ein verwendbares Kommunikationsprotokoll und/oder Informationen über eine zu verwendende oder verwendbare Schaltung der Adaptereinrichtung 18 umfassen.

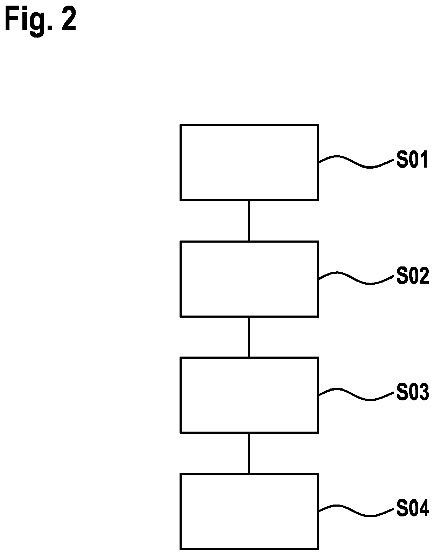

Figur 2 zeigt ein schematisches Flussdiagramm zum Erläutern eines Verfahrens gemäß einem zweiten Aspekt der vorliegenden Erfindung.

In einem Schritt S01 wird mindestens ein elektrischer Fahrzeugbatterie-Anschluss 44, 45, 46, 47 der Fahrzeugbatterie 40 mit einer elektrischen Anschlusseinrichtung 13 verbunden, beispielsweise über ein Kabel.

In einem weiteren Schritt S02 wird ein Stecker 32 der Prüfvorrichtung 30, welcher zum Anschluss an die On-Board-Diagnose-Schnittstelle des Fahrzeugs anschließbar ist, mit einer Schnittstelle 12 verbunden, etwa durch Einstecken des Steckers in die Schnittstelle.

In einem Verfahrensschritt S03 werden Signale, welche von dem mindestens einen elektrischen Fahrzeugbatterie-Anschluss 44, 45, 46, 47 der Fahrzeugbatterie 40 ausgehen, derart an die Schnittstelle 12 geleitet, dass die Signale an der Schnittstelle mittels des Steckers 32 entsprechend der Konfiguration der On-Board-Diagnose-Schnittstelle des Fahrzeugs prüfbar sind.

In einem Schritt S04 werden die Signale entsprechend der Konfiguration der On-Board-Diagnose-Schnittstelle des Fahrzeugs mittels der Prüfvorrichtung 30 geprüft.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Beispielsweise können an der Vorrichtung 10 weitere Schnittstellen ausgebildet sein, beispielsweise eine CAN-Bus-Schnittstelle, welche es der Vorrichtung ermöglichen, mit weiteren externen Geräten zu kommunizieren und/oder diese zu steuern. Dabei kann es sich um weitere Messeingänge zur Diagnose der Fahrzeugbatterie 40 handeln.

An der Vorrichtung kann auch ein Bildschirm vorgesehen sein. Mittels des Bildschirm kann etwa ein Ladevorgang der Fahrzeugbatterie mittels eines externen oder internen Ladegeräts der Vorrichtung graphisch angezeigt werden. Für den Ladevorgang kann eine Kennlinie vorgegeben werden, beispielsweise über eine Eingabeeinrichtung der Vorrichtung, oder über die angeschlossene Prüfvorrichtung.

## Patentansprüche

1. Vorrichtung (10) zum Prüfen einer Fahrzeugbatterie (40) in einem aus einem Fahrzeug ausgebauten Zustand mittels einer Prüfvorrichtung (30), welche zum Prüfen der in das Fahrzeug eingebauten Fahrzeugbatterie (40) mittels einer On-Board-Diagnose-Schnittstelle des Fahrzeugs ausgebildet ist, mit:
einer Schnittstelle (12), an welcher ein Stecker (32) der Prüfvorrichtung (30) anschließbar ist, welcher zum Anschluss an die On-Board-Diagnose-Schnittstelle des Fahrzeugs ausgebildet ist;
einer elektrischen Anschlusseinrichtung (13), mittels welcher mindestens ein elektrischer Fahrzeugbatterie-Anschluss (44, 45, 46, 47) der Fahrzeugbatterie (40) mit der Vorrichtung (10) verbindbar ist; und
einer Adaptereinrichtung (18), mittels welcher Signale, welche von dem mindestens einen elektrischen Fahrzeugbatterie-Anschluss (44, 45, 46, 47) der Fahrzeugbatterie (40) über die Anschlusseinrichtung (13) empfangbar sind, an die Schnittstelle (12) derart leitbar sind, dass die Signale an der Schnittstelle (12) für die Prüfvorrichtung (30) mittels des Steckers (32) entsprechend einer Konfiguration der On-Board-Diagnose-Schnittstelle des Fahrzeugs prüfbar sind.

2. Vorrichtung nach Anspruch 1, wobei die Anschlusseinrichtung (13) zumindest einen ersten Spannungsanschluss (16) und einen zweiten Spannungsanschluss (17) aufweist, an welche eine mittels der Fahrzeugbatterie (40) erzeugte Spannung anlegbar ist; und
wobei die Adaptereinrichtung (18) mit den Spannungsanschlüssen (16, 17) und der Schnittstelle (12) derart verbunden ist und so ausgebildet ist, dass zumindest die zwischen den Spannungsanschlüssen (16, 17) angelegte Spannung für die Prüfvorrichtung (20) zum Prüfen der Fahrzeugbatterie (40) an die Schnittstelle (12) derart leitbar ist, dass die Spannung an der Schnittstelle (12) entsprechend der Konfiguration der On-Board-Diagnose-Schnittstelle prüfbar ist.

3. Vorrichtung (10) nach einem der vorangehenden Ansprüche 1 oder 2 mit:
einem Spannungsversorgungsanschluss (19), mittels welchem eine Betriebsspannung (V) in die Vorrichtung (10) einkoppelbar ist, wobei die Betriebsspannung (V) mittels der Adaptereinrichtung (18) derart an die Schnittstelle (12) leitbar ist, dass die Betriebsspannung (V) zum Betrieb der Prüfvorrichtung (30) an der Schnittstelle (12) abgreifbar ist.

4. Vorrichtung nach einem der vorangehenden Ansprüche 1 bis 3, wobei ein Kommunikationsprotokoll, mittels welchem die Adaptereinrichtung (18) die Signale an die Schnittstelle (12) leitet, basierend auf vorbestimmten und/oder bestimmbaren Informationen über die Fahrzeugbatterie (40) und/oder über das Fahrzeug einstellbar ist.

5. Vorrichtung nach einem der vorangehenden Ansprüche 1 bis 4, wobei eine Schaltung, mittels welcher die Adaptereinrichtung (18) die Signale an die Schnittstelle (12) leitet, basierend auf Informationen über die Fahrzeugbatterie (40) einstellbar ist.

6. Vorrichtung nach einem der vorangehenden Ansprüche 1 bis 5 mit:
einer Lade-Steuerschnittstelle (24), mittels welcher ein an die Lade-Steuerschnittstelle (24) angeschlossenes Ladegerät zum Auf- und/oder Entladen der Fahrzeugbatterie (40) gemäß vorbestimmten und/oder bestimmbaren Ladeparametern steuerbar ist.

7. Vorrichtung nach einem der vorangehenden Ansprüche 1 bis 6 mit:
einer Ladeeinrichtung, mittels welcher die Fahrzeugbatterie (40) über die Anschlusseinrichtung (13) auf- und/oder entladbar ist.

8. Vorrichtung nach einem der vorangehenden Ansprüche 1 bis 7, wobei die Anschlusseinrichtung (13) mindestens einen Datenanschluss (14) aufweist, mittels welchem Daten empfangbar sind, welche von mindestens einem Datenausgang (44) der Fahrzeugbatterie (40) von der Fahrzeugbatterie (40) ausgebbar sind; und
wobei die Adaptereinrichtung (18) mit dem mindestens einen Datenanschluss (14) und der Schnittstelle (12) derart verbunden ist und so ausgebildet ist, dass die über den Datenanschluss (14) empfangenen Daten für die Prüfvorrichtung (20) zum Prüfen der Fahrzeugbatterie (40) derart an die Schnittstelle (12) leitbar sind, dass die Daten an der Schnittstelle (12) entsprechend der Konfiguration der On-Board-Diagnose-Schnittstelle prüfbar sind.

9. Vorrichtung nach einem der vorangehenden Ansprüche 1 bis 8 mit:
einer Simulationseinrichtung (22), mittels welcher eine Fahrzeugsimulation mit vorbestimmten und/oder bestimmbaren Parametern durchführbar ist;
wobei Fahrzeugsimulationsdaten der Fahrzeugsimulation über den mindestens einen Datenanschluss (14) an die Fahrzeugbatterie (40) sendbar sind; und
wobei die Fahrzeugsimulationsdaten derart beschaffen ist, dass die Fahrzeugbatterie (40) auf die Fahrzeugsimulationsdaten reagiert, als befände sie sich in dem Fahrzeug mit den vorbestimmten und/oder bestimmbaren Parametern.

10. Verfahren zum Prüfen einer Fahrzeugbatterie (40) in einem aus einem Fahrzeug ausgebauten Zustand mittels einer Prüfvorrichtung (30), welche zum Prüfen der in das Fahrzeug eingebauten Fahrzeugbatterie (40) mittels einer On-Board-Diagnose-Schnittstelle des Fahrzeugs ausgebildet ist, mit:
Verbinden (S01) mindestens eines elektrischen Fahrzeugbatterie-Anschlusses (44, 45, 46, 47) der Fahrzeugbatterie (40) mit einer elektrischen Anschlusseinrichtung (13);
Verbinden (S02) eines Steckers (32) der Prüfvorrichtung (30), welcher zum Anschluss an die On-Board-Diagnose-Schnittstelle des Fahrzeugs anschließbar ist, mit einer Schnittstelle (12);
Leiten (S03) von Signalen, welche von dem mindestens einen elektrischen Fahrzeugbatterie-Anschluss (44, 45, 46, 47) der Fahrzeugbatterie (40) ausgehen, derart an die Schnittstelle (12), dass die Signale an der Schnittstelle (12) für die Prüfvorrichtung (30) mittels des Steckers (32) entsprechend einer Konfiguration der On-Board-Diagnose-Schnittstelle des Fahrzeugs prüfbar sind; und
Prüfen (S04) der Signale entsprechend der Konfiguration der On-Board-Diagnose-Schnittstelle des Fahrzeugs mittels der Prüfvorrichtung (30).

## Claims

1. Device (10) for testing a vehicle battery (40) in a state uninstalled from a vehicle by way of a test device (30) that is designed to test the vehicle battery (40) installed in the vehicle by way of an on-board diagnosis interface of the vehicle, having:
an interface (12) to which a plug (32) of the test device (30) is able to be connected, which plug is designed to be connected to the on-board diagnosis interface of the vehicle;
an electrical connection apparatus (13) by way of which at least one electrical vehicle battery connection (44, 45, 46, 47) of the vehicle battery (40) is able to be connected to the device (10); and
an adapter apparatus (18) by way of which signals that are able to be received from the at least one electrical vehicle battery connection (44, 45, 46, 47) of the vehicle battery (40) via the connection apparatus (13) are able to be channelled to the interface (12) such that the signals are able to be tested at the interface (12) for the test device (30) by way of the plug (32) in accordance with a configuration of the on-board diagnosis interface of the vehicle.

2. Device according to Claim 1, wherein the connection apparatus (13) has at least a first voltage connection (16) and a second voltage connection (17) to which a voltage generated by way of the vehicle battery (40) is able to be applied; and
wherein the adapter apparatus (18) is connected to the voltage connections (16, 17) and the interface (12) and is designed such that at least the voltage applied between the voltage connections (16, 17) for the test device (20) for testing the vehicle battery (40) is able to be channelled to the interface (12) such that the voltage at the interface (12) is able to be tested in accordance with the configuration of the on-board diagnosis interface.

3. Device (10) according to either of preceding Claims 1 and 2, having:
a voltage supply connection (19) by way of which an operating voltage (V) is able to be coupled into the device (10), wherein the operating voltage (V) is able to be channelled to the interface (12) by way of the adapter apparatus (18) such that the operating voltage (V) for operating the test device (30) is able to be tapped off at the interface (12).

4. Device according to one of preceding Claims 1 to 3, wherein a communication protocol by way of which the adapter apparatus (18) channels the signals to the interface (12) is able to be set based on predetermined and/or determinable information about the vehicle battery (40) and/or about the vehicle.

5. Device according to one of preceding Claims 1 to 4, wherein a circuit, by way of which the adapter apparatus (18) channels the signals to the interface (12), is able to be set based on information about the vehicle battery (40) .

6. Device according to one of preceding Claims 1 to 5, having:
a charging control interface (24) by way of which a charger connected to the charging control interface (24) is able to be controlled so as to charge and/or discharge the vehicle battery (40) in accordance with predetermined and/or determinable charging parameters.

7. Device according to one of preceding Claims 1 to 6, having:
a charging apparatus by way of which the vehicle battery (40) is able to be charged and/or discharged via the connection apparatus (13).

8. Device according to one of preceding Claims 1 to 7, wherein the connection apparatus (13) has at least one data connection (14) by way of which it is possible to receive data that are able to be output from the vehicle battery (40) by at least one data output (44) of the vehicle battery (40); and
wherein the adapter apparatus (18) is connected to the at least one data connection (14) and the interface (12) and is designed such that the data, received via the data connection (14), for the test device (20) for testing the vehicle battery (40) are able to be channelled to the interface (12) such that the data are able to be tested at the interface (12) in accordance with the configuration of the on-board diagnosis interface.

9. Device according to one of preceding Claims 1 to 8, having:
a simulation apparatus (22) by way of which a vehicle simulation is able to be performed with predetermined and/or determinable parameters;
wherein vehicle simulation data of the vehicle simulation are able to be transmitted to the vehicle battery (40) via the at least one data connection (14); and
wherein the vehicle simulation data are provided such that the vehicle battery (40) responds to the vehicle simulation data as if it were located in the vehicle with the predetermined and/or determinable parameters.

10. Method for testing a vehicle battery (40) in a state uninstalled from a vehicle by way of a test device (30) that is designed to test the vehicle battery (40) installed in the vehicle by way of an on-board diagnosis interface of the vehicle, comprising:
connecting (S01) at least one electric vehicle battery connection (44, 45, 46, 47) of the vehicle battery (40) to an electrical connection apparatus (13);
connecting (S02) a plug (32) of the test device (30), which plug is able to be connected for connection to the on-board diagnosis interface of the vehicle, to an interface (12);
channelling (S03) signals coming from the at least one electrical vehicle battery connection (44, 45, 46, 47) of the vehicle battery (40) to the interface (12) such that the signals are able to be tested at the interface (12) for the test device (30) by way of the plug (32) in accordance with a configuration of the on-board diagnosis interface of the vehicle; and
testing (S04) the signals in accordance with the configuration of the on-board diagnosis interface of the vehicle by way of the test device (30).

## Revendications

1. Dispositif (10) pour tester une batterie de véhicule (40) dans un état déposé d'un véhicule, au moyen d'un dispositif de test (30) qui est réalisé pour tester la batterie de véhicule (40) installée sur le véhicule au moyen d'une interface de diagnostic embarqué du véhicule, comprenant :
une interface (12) à laquelle un connecteur (32) du dispositif de test (30) peut être connecté qui est réalisé pour être connecté à l'interface de diagnostic embarqué du véhicule ;
un équipement de connexion électrique (13) au moyen duquel au moins une borne de batterie de véhicule électrique (44, 45, 46, 47) de la batterie de véhicule (40) peut être reliée au dispositif (10) ; et
un équipement d'adaptation (18) au moyen duquel des signaux, qui peuvent être reçus par ladite au moins une borne de batterie de véhicule électrique (44, 45, 46, 47) de la batterie de véhicule (40) par l'intermédiaire de l'équipement de connexion (13), peuvent être acheminés à l'interface (12) de telle sorte que les signaux au niveau de l'interface (12) pour le dispositif de test (30) peuvent être testés au moyen du connecteur (32) selon une configuration de l'interface de diagnostic embarqué du véhicule.

2. Dispositif selon la revendication 1, dans lequel l'équipement de connexion (13) présente au moins une première borne de tension (16) et une deuxième borne de tension (17) auxquelles une tension produite au moyen de la batterie de véhicule (40) peut être appliquée ; et
l'équipement d'adaptation (18) étant relié aux bornes de tension (16, 17) et à l'interface (12), et étant réalisé de telle sorte qu'au moins la tension appliquée entre les bornes de tension (16, 17) pour le dispositif de test (20) pour tester la batterie de véhicule (40) peut être acheminée à l'interface (12) de telle sorte que la tension au niveau de l'interface (12) peut être testée selon la configuration de l'interface de diagnostic embarqué.

3. Dispositif (10) selon l'une quelconque des revendications précédentes 1 ou 2, comprenant :
une borne d'alimentation de tension (19) au moyen de laquelle une tension de fonctionnement (V) peut être injectée dans le dispositif (10), la tension de fonctionnement (V) pouvant être acheminée au moyen de l'équipement d'adaptation (18) à l'interface (12) de telle sorte que la tension de fonctionnement (V) pour le fonctionnement du dispositif de test (30) peut être prélevée au niveau de l'interface (12).

4. Dispositif selon l'une quelconque des revendications précédentes 1 à 3, dans lequel un protocole de communication au moyen duquel l'équipement d'adaptation (18) achemine les signaux à l'interface (12) peut être réglé sur la base d'informations prédéterminées et/ou déterminables concernant la batterie de véhicule (40) et/ou le véhicule.

5. Dispositif selon l'une quelconque des revendications précédentes 1 à 4, dans lequel un circuit au moyen duquel l'équipement d'adaptation (18) achemine les signaux à l'interface (12) est réglable sur la base d'informations concernant la batterie de véhicule (40).

6. Dispositif selon l'une quelconque des revendications précédentes 1 à 5, comprenant :
une interface de commande de charge (24) au moyen de laquelle un chargeur connecté à l'interface de commande de charge (24) pour recharger et/ou décharger la batterie de véhicule (40) peut être commandé selon des paramètres de charge prédéterminés et/ou déterminables.

7. Dispositif selon l'une quelconque des revendications précédentes 1 à 6, comprenant :
un équipement de charge au moyen duquel la batterie de véhicule (40) peut être rechargée et/ou déchargée par l'intermédiaire de l'équipement de connexion (13).

8. Dispositif selon l'une quelconque des revendications précédentes 1 à 7,
dans lequel l'équipement de connexion (13) présente au moins une borne de données (14) au moyen de laquelle des données peuvent être reçues qui peuvent être sorties par la batterie de véhicule (40) par au moins une sortie de données (44) de la batterie de véhicule (40) ; et
dans lequel l'équipement d'adaptation (18) est relié à ladite au moins une borne de données (14) et à l'interface (12), et est réalisé de telle sorte que les données reçues par l'intermédiaire de la borne de données (14) pour le dispositif de test (20) pour tester la batterie de véhicule (40) peuvent être acheminées à l'interface (12) de telle sorte que les données au niveau de l'interface (12) peuvent être testées selon la configuration de l'interface de diagnostic embarqué.

9. Dispositif selon l'une quelconque des revendications précédentes 1 à 8, comprenant :
un équipement de simulation (22) au moyen duquel une simulation de véhicule peut être effectuée avec des paramètres prédéterminés et/ou déterminables ;
des données de simulation de véhicule de la simulation de véhicule pouvant être envoyées par ladite au moins une borne de données (14) à la batterie de véhicule (40) ; et
les données de simulation de véhicule étant telles que la batterie de véhicule (40) répond aux données de simulation de véhicule comme si elle se trouvait sur le véhicule avec les paramètres prédéterminés et/ou déterminables.

10. Procédé pour tester une batterie de véhicule (40) dans un état déposé d'un véhicule, au moyen d'un dispositif de test (30) qui est réalisé pour tester la batterie de véhicule (40) installée sur le véhicule au moyen d'une interface de diagnostic embarqué du véhicule, comprenant les étapes consistant à :
relier (S01) au moins une borne de batterie de véhicule électrique (44, 45, 46, 47) de la batterie de véhicule (40) à un équipement de connexion électrique (13) ;
relier (S02) à une interface (12) un connecteur (32) du dispositif de test (30) qui peut être connecté pour la connexion à l'interface de diagnostic embarqué du véhicule ;
acheminer (S03) des signaux qui proviennent de ladite au moins une borne de batterie de véhicule électrique (44, 45, 46, 47) de la batterie de véhicule (40) à l'interface (12) de telle sorte que les signaux au niveau de l'interface (12) peuvent être testés pour le dispositif de test (30) au moyen du connecteur (32) selon une configuration de l'interface de diagnostic embarqué du véhicule ; et
tester (S04) les signaux selon la configuration de l'interface de diagnostic embarqué du véhicule au moyen du dispositif de test (30).
